(19) Europäisches Patentamt / European Patent Office / Office européen des brevets

(11) **EP 4 453 274 B1**

(12) **EUROPÄISCHE PATENTSCHRIFT**

(45) Veröffentlichungstag und Bekanntmachung des Hinweises auf die Patenterteilung:
**01.04.2026 Patentblatt 2026/14**

(21) Anmeldenummer: **23707718.5**

(22) Anmeldetag: **27.02.2023**

(51) Internationale Patentklassifikation (IPC):
*C23C 16/40* (2006.01)    *C23C 16/511* (2006.01)
*C23C 16/515* (2006.01)    *C23C 16/04* (2006.01)
*C23C 16/02* (2006.01)    *C08J 7/048* (2020.01)
*C08J 7/04* (2020.01)    *B05D 1/00* (2006.01)
*B05D 3/04* (2006.01)    *B05D 7/02* (2006.01)
*B05D 7/22* (2006.01)    *B05D 3/02* (2006.01)
*B05D 3/06* (2006.01)

(52) Gemeinsame Patentklassifikation (CPC):
**C23C 16/401; B05D 1/60; B05D 1/62; B05D 3/0486; B05D 7/02; B05D 7/227; C08J 7/0427; C08J 7/043; C08J 7/048; C23C 16/029; C23C 16/045; C23C 16/511; C23C 16/515;** B05D 3/029; B05D 3/0406;    (Forts.)

(86) Internationale Anmeldenummer:
**PCT/EP2023/054778**

(87) Internationale Veröffentlichungsnummer:
**WO 2023/165913 (07.09.2023 Gazette 2023/36)**

(54) **BESCHICHTUNGSTECHNIK FÜR KUNSTSTOFFBEHÄLTER**

COATING TECHNOLOGY FOR PLASTIC CONTAINERS

TECHNOLOGIE DE REVÊTEMENT POUR RÉCIPIENTS EN MATIÈRE PLASTIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **03.03.2022 DE 102022105041**

(43) Veröffentlichungstag der Anmeldung:
**30.10.2024 Patentblatt 2024/44**

(73) Patentinhaber: **IonKraft GmbH**
**52068 Aachen (DE)**

(72) Erfinder: **JARITZ, Montgomery**
**53332 Bornheim (DE)**

(74) Vertreter: **ERNICKE Patent- und Rechtsanwälte PartmbB**
**Beim Glaspalast 1**
**86153 Augsburg (DE)**

(56) Entgegenhaltungen:
WO-A2-01/94448     TW-A- 201 229 306
US-A1- 2009 148 633     US-A1- 2019 015 561

(52)  Gemeinsame Patentklassifikation (CPC): (Forts.)
      B05D 3/06; B05D 2201/02; B05D 2259/00;
      B05D 2350/60; B05D 2401/33; B05D 2490/50;
      B05D 2518/10; B05D 2518/12; C08J 2323/02;
      C08J 2467/02

**Beschreibung**

Die Erfindung liegt auf dem Gebiet der Kunststoffbeschichtung mittels plasmaunterstützter chemischer Gasphasenabscheidung (engl.: Plasma Enhanced Chemical Vapour Deposition, PECVD).

In der Industrie werden Kunststoffbehälter, z.B. Flaschen oder Kanister, zur Lagerung verschiedenster Flüssigkeiten eingesetzt. Die Eigenschaften des Kunststoffs wirken sich auf die Eignung des Materials zur Lagerung des jeweiligen Mediums sowie auf die Herstellungskosten des Behälters aus.

Die Eignung des Materials hängt insbesondere von den Permeationseigenschaften des Kunststoffs gegenüber verschiedenen Gasen (z.B. Sauerstoff aus der Umgebungsluft), Lösemitteln, Aromaten, Farbstoffen oder sonstigen Stoffen sowie der Beständigkeit des Kunststoffs gegenüber dem zu lagernden Medium (z.B. saure oder alkalische Medien) ab.

Zur sicheren Lagerung des Mediums, z.B. einer alkalischen Lösung, soll das Medium vor eindringenden Substanzen aus der Umgebung oder dem Verlust von Substanzen geschützt werden. Füllgut aus dem Behälter darf nicht in die Umgebung gelangen. Gase und andere Stoffe können jedoch, je nach Eigenschaft des Behältermaterials, durch die Behälterwandung hindurch diffundieren (Permeation). Die Barriereleistung des Behältermaterials beschreibt, wie gut der Behälter bzw. das gelagerte Medium vor Permeation geschützt ist.

Außerdem soll das Medium selbst nicht aus dem Behälter austreten oder den Behälter beschädigen. Das Material des Behälters muss dem zu lagernden Medium über längere Zeit standhalten und eine ausreichende Lagersicherheit gewährleisten. Gerade bei der Lagerung von Chemikalien, von denen viele Stoffe zu den Gefahrgütern zählen, werden hohe Anforderungen an die Beständigkeit der Behälterwerkstoffe gestellt.

Grundsätzlich ist die Fertigung von Behältern aus Kunststoff, z.B. durch Extrusionsblasformen, ein in der Industrie beliebter Ansatz, da er eine kostengünstige Herstellung der Behälter erlaubt und Kunststoffbehälter einfach zu lagern sind. Der Stand der Technik kennt jedoch keinen kostengünstigen Kunststoff, der gleichzeitig eine ausreichende Barriereleistung und Beständigkeit gegenüber aggressiven, insbesondere alkalischen oder sauren, Medien bietet.

Im Stand der Technik werden zur Lagerung aggressiver Medien daher häufig keine Kunststoffe oder besondere Verbundkunststoffe eingesetzt, die teuer in der Fertigung oder aufwändig zu transportieren oder lagern sind.

Eingesetzt werden oft durch Koextrusionsblasformen hergestellte Behälter, deren Wände aus mehreren Lagen unterschiedlicher Kunststoffe bestehen. Häufig wird eine Mischung von Hart-Polyethylen (HD-PE), Polyamid (PA) und/oder Ethylen-Vinylalkohol-Copolymer (EVOH) eingesetzt. HD-PE ist gegen Säuren, Laugen, Öle und Fette sehr beständig, hat aber eine hohe Durchlässigkeit gegen bestimmte Stoffe, weswegen EVOH und/oder PA zum Einsatz kommen. Diese Verpackungen aus Verbundkunststoffen sind nicht umweltfreundlich, da nur Monomateriallösungen stofflich nachhaltig recycelt werden können.

Neben dem Einsatz von nicht recyclingfähigen Kunststoff-Multimateriallösungen gibt es zur Barriereausrüstung von Kunststoffen nur noch die Möglichkeit der Fluorierung oder der Beschichtung mittels Plasmatechnologie. Bei der Fluorierung werden die Behälter in eine Vakuumkammer verbracht und dort unter Ausschluss von Atmosphäre einem Fluorgasgemisch ausgesetzt. Durch seine hohe Reaktivität ersetzt Fluor partiell Wasserstoffatome an der Materialoberfläche. Hierdurch wird aber lediglich eine Adsorptionsbarriere erzeugt, welche ausschließlich die Migration von Medien wie Lösemitteln verhindern kann. Fluor ist zudem giftig und stark ätzend, was diese Technologie unattraktiv und teuer macht. Weiterhin gibt es immer mehr Studien, die fluorierten Kunststoffen negative Umwelt- und Gesundheitseinflüsse zuweisen.

Plasmapolymere Beschichtungen hingegen sind nicht nur günstig, zu ihrer Herstellung können zudem unbedenkliche Chemikalien eingesetzt werden und nur ein geringer Energie- und Materialeinsatz ist notwendig. Mittels PECVD können fluorfreie siliziumbasierte Barrierebeschichtungen erzeugt werden, die als passive Barriere die Migration beliebiger Stoffe unterbinden können. Somit eignen sich die Beschichtungen gleichzeitig beispielsweise als Lösemittelbarriere, Barriere gegen die Migration jeglicher Kontaminanten aus einem Kunststoffrezyklat in ein Füllgut oder als Gasbarriere beispielsweise gegen Sauerstoff, Wasserstoff oder Kohlendioxid, was ein großes Spektrum möglicher Anwendungen eröffnet.

DE 36 32 748 A1 beschreibt ein Verfahren zur PEVCD-Beschichtung von Hohlkörpern im Niederdruck, welches heute breite industrielle Anwendung findet. Hierbei wird zunächst die gesamte Vakuumkammer zusammen mit der zu beschichtenden Flasche auf den notwendigen Arbeitsdruck evakuiert. Daraufhin werden die Prozessgase in das Flascheninnere eingeleitet und mittels Mikrowellen zum Plasma angeregt. Das Plasma zündet innerhalb der Flasche und eine Barrierebeschichtung kann appliziert werden.

Im Vergleich zu den konkurrierenden Verfahren zur Permeationsminderung sind plasmapolymere Beschichtungen nicht nur günstig, sondern auch umweltfreundlich, da zu ihrer Herstellung nur ein geringer Energie- und Materialeinsatz notwendig ist und auf Lösemittel oder andere bedenkliche Chemikalien verzichtet werden kann. Dies gilt aufgrund ihres geschlossenen Reaktionsraums und minimaler eingesetzter Prozessgasmengen insbesondere für Niederdruckplasmaprozesse.

Die aus dem Stand der Technik bekannten siliziumoxidischen $SiO_x$-Barrierebeschichtungen sind äußerst

hydrolyseanfällig, sodass diese bereits bei Kontakt mit Füllgütern mit geringfügig erhöhten pH-Werten > 7 zersetzt werden.

Aus DE 10 2006 048 658 A1 ist eine mehrlagige Verbundbeschichtung bekannt, welche aus einer $SiO_x$-Barriereschicht und einer siliziumorganischen Passivierungsschicht besteht.

Ein Nachteil dieser mehrlagigen Verbundbeschichtungen, deren Lagen nacheinander (häufig in getrennten Prozessschritten) aufgebaut werden, ist, dass sich aufgrund der für PECVD-Prozesse typischen Schichtwachstumsmechanismen Defekte und Poren in einer zugrundeliegenden Schicht als Fehler in einer nachfolgenden Beschichtung fortpflanzen, sodass derartige Schichtsysteme immer eine offene Porosität aufweisen.

Solche PECVD-Verfahren zur Abscheidung einer Barriereschicht gegen Gaspermeation sowie einer schützenden Passivierungsschicht auf Kunststoffbehältern (sog. Verbundbeschichtungen) werden heutzutage hauptsächlich im Bereich der Getränkeindustrie eingesetzt.

Für bestimmte Füllgüter, z.B. aggressive alkalische Chemikalien, die eine hohe mechanische Stabilität der Behälter, eine hohe Barriereleistung gegen Gase und Lösemittel sowie eine hohe Beständigkeit gegen saure und alkalische Medien erfordern, sind die bekannten Verbundbeschichtungen nicht geeignet oder zumindest optimierungsbedürftig.

Durch die Wachstumsvorgänge der stofflich unterschiedlichen Schichten der Verbundschicht entstehen Poren in der Schichtoberfläche. Diese Poren bewirken unter anderem Lücken in der Passivierungsschicht, durch die die darunterliegende Barriereschicht dem aggressiven Medium ausgesetzt ist. Poren können insbesondere durch sog. Inselwachstum während der Schichtabscheidung entstehen. Inselwachstum verhindert eine homogene Schichtausbildung.

Das Schichtwachstum bei der PECVD stellt in seiner Gesamtheit einen komplexen Vorgang dar und wird maßgeblich von der Konkurrenz aus Kinetik und Thermodynamik geprägt. Zu Beginn des Beschichtungsprozesses in der PECVD werden schichtbildende Teilchen zur Substratoberfläche beschleunigt. Nach dem Auftreffen werden sie bei zu geringer kinetischer Energie wieder von der Oberfläche reflektiert. Bei ausreichend großer kinetischer Energie werden sie als Adatome adsorbiert. Solche Adatome diffundieren anschließend über die Oberfläche des Substrates bis sie entweder wieder desorbieren oder mit anderen Adatomen kondensieren, Keime bilden und in der Schicht ihre endgültige Position finden. Die Oberflächenenergie der zu beschichtenden Oberfläche trägt hierbei maßgeblich zur Beweglichkeit der Adatome und somit zur Art des Schichtwachstums bei. Sind die Oberflächenenergien von Schichtmaterial und Substratmaterial ähnlich, so wird ein homogenes Lagenwachstum begünstigt.

Inselwachstum tritt vor allem dann auf, wenn das Substrat eine geringere Oberflächenenergie als die sich bildende Schicht hat, wodurch die Wechselwirkung zwischen Substrat und Adatom geringer als die Wechselwirkung zwischen den Teilchen ist. Dann wächst das Schichtmaterial vorzugsweise in dreidimensionalen Inseln auf. Da die Kondensation von Atomen auf dem Substrat bei diesem Wachstumsmodus zunächst nicht thermodynamisch favorisiert ist, bilden sich beim Inselwachstum erst mit fortschreitendem Schichtwachstum und dem Zusammenwachsen von Inseln geschlossene Schichten aus.

Weiterhin kommt es je nach Plasmaprozess und Reaktortyp im Plasma zu einer unterschiedlichen Anzahl von Stößen, bis die reaktiven Teilchen das Substrat erreichen. Bei wenig Stößen finden nur wenige Reaktionen in der Gasphase statt, sodass die Depositionsrate abnimmt. Führen die Teilchen bzw. Radikale viele Stöße bzw. Reaktionen bis zum Erreichen des Substrates aus, kann es zur Volumenpolymerisation kommen, bei der bereits in der Gasphase Oligomere gebildet werden. Je größer die Teilchen, desto geringer die Wahrscheinlichkeit für Oberflächendiffusion, sodass es vermehrt zu Inselwachstum kommt und die Schichten später geschlossen vorliegen, da die Inseln erst zusammenwachsen müssen.

Inselwachstum führt somit zu einer körnigen Oberflächenstruktur und in der Folge zu nanoskopischen Poren an den Korngrenzen der zusammenwachsenden Inseln. Wenn mehrere Korngrenzen aufeinandertreffen, entstehen Poren. Die laterale Ausdehnung der Poren liegt im Bereich mehrerer Nanometer. Damit sind diese Schichtdefekte wesentlich größer als beispielsweise molekularer Sauerstoff oder Ionen einer alkalischen Lösung und stellen somit Schwachstellen im Schichtsystem dar.

Befinden sich derartige Poren in einer zugrundeliegenden $SiO_x$-Schicht (Barriereschicht), tritt an diesen eine erhöhte Keimbildung auf, sodass sich hier Agglomerate ausbilden, was zu einer Fortführung dieser Schichtdefekte in eine mögliche darauffolgende Schutzschicht (Passivierungsschicht) resultiert.

In Versuchen wurde gezeigt, dass sich in $SiO_x$-Schichten, die auf Kunststoff oder siliziumorganische Haftvermittlerschichten abgeschieden werden, immer eine große Zahl nanoskopischer Poren ausbildet, die unter anderem mittels elektrochemischer Methoden, wie Cyclovoltammetrie oder elektrochemische Impedanzspektroskopie, nachgewiesen werden können.

Begründet werden kann dies u.a. durch die unterschiedlichen Oberflächenenergien und chemischen Zusammensetzungen der Materialien, sowie vermehrte Volumenpolymerisation. Messungen vorhandener Poren nach dem weiteren Auftrag einer siliziumorganischen Passivierungsschicht auf die $SiO_x$-Schichten zeigten, dass die Anzahl nanoskopischer Poren durch die weitere Beschichtung kaum zurückgeht.

Beim Einsatz der aus dem Stand der Technik bekannten Verbundbeschichtungen kommt es daher zu einem poren- oder defektgetriebenen Versagen des Systems unter Einwirkung chemisch aggressiver Medien. Durch offene Poren kann diese zu der unter der Passivierungsschicht liegenden hydrolyseanfälligen Barriereschicht gelangen und beginnen, diese zu zersetzen. Es kommt zu einer Unterwanderung der Schutzschicht und zum Versagen des Gesamtsystems. Zur industriellen Lagerung von Chemikalien ist dieses Schichtsystem daher nicht geeignet.

Ein Ansatz zur Lösung dieser Probleme von Verbundschichten ist der Einsatz sogenannter Gradientenschichten, bei denen sich die chemische Zusammensetzung graduell entlang der Schichtdicke zwischen organisch (Passivierung oder Haftvermittlung) und oxidisch (Migrationsbarriere) verändert. Im Gegensatz zu Verbundschichten, die aus wenigen stofflich scharf unterscheidbaren (Mikro-)Lagen bestehen, weisen Gradientenschichten einen kontinuierlichen Gradienten in der stofflichen Zusammensetzung entlang der Schichtdicke auf.

Gradientenschichten sind aus anderen Bereichen der Technik, z.B. als Kratzschutzschicht auf Brillengläsern aus Kunststoff, bekannt.

Aus EP 0 718 418 A1 ist bekannt, dass zur Erzeugung einer PECVD-Gradientenschicht der Parameter der Plasmapulsung bei sonst gleichbleibenden Parametern eingesetzt werden kann. Dieser Parameter eignet sich aber nur zur Abscheidung von beispielsweise Kratzschutzschichten, für die keine großen Unterschiede in der chemischen Zusammensetzung benötigt werden, sodass die gleiche Gaszusammensetzung während der gesamten Schichtabscheidung genutzt werden kann.

DE 42 38 279 A1 offenbart ein weiteres Beschichtungsverfahren zur Erzeugung einer Kratzschutzschicht.

Aus EP 2 630 273 B1 ist ein Verfahren zur Plasmabehandlung von Werkstücken bekannt, bei dem die Zündung des Plasmas mit gepulster Mikrowellenenergie erfolgt, wobei die Relation zwischen der Dauer der Einschaltphasen und der Ausschaltphasen verändert wird. Der Quotient aus der Einschaltzeit und der Ausschaltzeit wird während des Beschichtungsvorgangs zunächst vergrößert und anschließend wieder verkleinert, um einen Kohlenstoffanteil in einer Barriereschicht zunächst zu vermindern und anschließend wieder zu vergrößern.

Aus DE 197 32 217 C2 ist eine Plasmabeschichtung eines photovoltaischen Halbleiterbauelements mit einer Gradientenschicht mit sich graduell ändernden Schichteigenschaften durch Variation der Plasmaparameter und der Gaszufuhr bekannt. Die Gradientenschicht umfasst eine Diffusionssperrsicht, eine elastische Polymer-Schutzschichtzone und eine kratzfeste Oberflächenschicht. Die Abscheidung erfolgt in einem Mikrowellenplasma. Das Verfahren ist nicht dafür geeignet auf einem Kunststoffsubstrat die geforderten Schichteigenschaften für Kunststoffbehälter für aggressive Medien wie Chemikalien zu erzeugen. Insbesondere fehlt ein Hinweis, wie und anhand welcher Prozessparameter die Plasmaleistung zu steuern ist, um die gewünschte Gradientenschicht zu erzeugen.

Aus DE 101 39 305 A1 ist ein PICVD-Verfahren in einem gepulstem Mikrowellenplasma für Pharmaverpackungen bekannt, das jedoch keine ausreichende Passivierungsschicht umfasst.

Aus WO 01/94448 A2 ist eine Beschichtung für Getränkeflaschen mit verbesserter Barriere gegen Gaspermeation bei geringer Wanddicke und guter Recyclingfähigkeit bekannt. Es wird eine Beschichtung mit einer SiOxCyHz-Basislage mit organischen Bestandteilen und darauf aufgebrachter Barrierelage vorgeschlagen. Als eine Ausführungsform wird ein Kontinuum-Schichtaufbau mit variabler Komposition ausgehend von SiOxCyHz auf der Substratseite bis zu SiOx auf der Außenseite der Beschichtung offenbart. Solche Beschichtungen weisen keine ausreichende Resistenz gegen chemisch aggressive Medien (z.B. Natronlauge) auf.

Aus US 2009/148633 A1 ist eine Plasma-CVD-Beschichtung auf einer Plastikflasche mit einer Haftschicht mit höherer Kohlenstoffkonzentration, eine Barrierezwischenschicht mit niedriger Kohlenstoffkonzentration und einer Oberflächenschutzschicht mit höherer Kohlenstoffkonzentration bekannt. Mit dieser Technik können Beschichtung für Getränkeflaschen erzeugt werden, die dem leicht alkalischen Einfluss von Mineralwasser (pH 7,3) stand halten, aber bei stärker korrosiven Medien ebenfalls versagen.

Zur Erzeugung einer porenfreien Gradientenschicht, die ein breites Spektrum der chemischen Zusammensetzung von hochoxidiert ($SiO_x$) für Barriere bis zu siliziumorganisch (SiOCH) für Korrosionsschutz abbilden kann, sind die bekannten Verfahren nicht ausreichend.

Insbesondere ist eine alleinige Veränderung der Pulsquotienten nicht ausreichend, um die gewünschte Bandbreite zwischen Barriere- und Passivierungswirkung in einer zusammenhängenden Gradientenschicht zu erzielen und gleichzeitig ein homogenes porenfreies Schichtwachstum sicherzustellen.

In Bezug auf die aus EP 2 630 273 B1 vorbekannte Lösung ist es mit der vorliegenden Erfindung möglich, eine vorteilhafte Gradientenschicht abzuscheiden, bei der die Pulsparameter, insbesondere der Quotient aus Einschaltzeit und Ausschaltzeit, nicht zwangsläufig zuerst erhöht und anschließend verringert wird. Vielmehr hat sich in der Forschung gezeigt, dass die gezielte Steuerung der Energiedichte im Plasma in Abhängigkeit der Gaszusammensetzung einen wesentlichen Einfluss auf die Beschichtungseigenschaften hat. So ist es beispielsweise möglich, die Energiedichte im Plasma bei zumindest zunächst konstantem Quotienten zwischen der Einschaltzeit und Ausschaltzeit der Pulse durch die Energiezufuhr, die absolute Dauer der Pulse und/oder die Gaszusammensetzung zu steuern.

Die aus dem Stand der Technik bekannten Gradientenschichten, z.B. Kratzschutzschichten, sind außerdem aufgrund Ihrer mechanischen Eigenschaften ungeeignet. Kratzschutzschichten mit einer Dicke von über einem Mikrometer, häufig über zwei oder drei Mikrometer, tendieren bei mechanischer Belastung zur Rissbildung oder brechen an belasteten Stellen, sodass die chemische Schutzwirkung leidet.

Eine Weiterentwicklung der bereits in den 90er Jahren entwickelten Verfahren zur Abscheidung von Gradientenschichten wurde außerdem durch die hohen Reaktionszeiten der auf dem Markt erhältlichen Massflussreglern von ca. 0,5 Sekunden begrenzt. Eine für die Ausbildung porenfreier Gradientenschichten mit einer Gradientenauflösung weniger Nanometer war mit der damals verfügbaren Technik nicht möglich.

Aufgabe der vorliegenden Erfindung ist es daher, eine verbesserte Beschichtungstechnik für Kunststoffbehälter aufzuzeigen.

Es hat sich gezeigt, dass zur Ausbildung einer chemisch beständigen Beschichtung mit guter Barriereleistung besondere Verfahrensbedingungen und Schichteigenschaften notwendig sind.

Um eine zur Lagerung von Chemikalien ausreichend hohe chemische Beständigkeit ausbilden zu können, müssen siliziumorganische Beschichtungen mit hohem Kohlenstoffgehalt, vorzugsweise durch Retention von Methylgruppen aus dem Präkursor, erzeugt werden.

Aus siliziumorganischen Präkursoren abgeschiedene plasmapolymere Schichten (zum Beispiel Siliziumoxid-Barriereschichten) bestehen aus Silizium, Kohlenstoff, Wasserstoff, Sauerstoff und/oder Stickstoff. Die typische Unbeständigkeit solcher Schichten gegen beispielsweise alkalische Medien ist auf die hohe Elektronegativitätsdifferenz von Sauerstoff/Stickstoff und Silizium zurückzuführen, denn in Lösung befindliche Ionen brechen vornehmlich Bindungen mit hohen Partialladungsverschiebungen auf. Je anorganischer, bzw. oxidierter die Schichten sind, desto mehr positive Partialladungen an Kohlenstoff- und vor allem Siliziumatomen liegen vor. Da die Elektronegativitätsdifferenz zwischen Silizium und Sauerstoff größer ist als zwischen Silizium und Kohlenstoff, besitzt das Silizium die größte positive Partialladung, was diese Bindungen und damit vor allem die oft eingesetzten $SiO_x$-Barriereschichten besonders anfällig macht.

Im Rahmen der Forschung hat sich gezeigt, dass es in einem engen Prozessfenster von Energiedichte im Plasma, Gaszusammensetzung, Prozessdruck und -temperatur gelingen kann, die im Präkursor, z.B. Hexamethyldisiloxan (HMDSO)-Molekül, enthaltenen Methylgruppen im Plasma zu erhalten, Volumenpolymerisation zu unterbinden und diese somit in die Schichten einzubauen. In Anbetracht der Strukturformel und den Bindungsenergien im HMDSO-Molekül erfolgt bei der PECVD von HMDSO im Plasma zunächst eine Abspaltung der Methylgruppen und anschließend des Wasserstoffs. Normalerweise werden diese Gruppen im Plasma fragmentiert, reagieren mit anderen Teilchen zu flüchtigen Komponenten und verlassen den Reaktionsraum, ohne an der Schichtbildung teilzunehmen.

Durch den Erhalt der Methylgruppen kann eine erhöhte Beständigkeit der Schichten durch den Wirkmechanismus der sterischen Abschirmung erreicht werden. Unter einer sterischen Abschirmung wird die räumliche Abschirmung einer schwachen Bindung durch benachbarte, raumfüllende Substituenten bezeichnet. Als Substituent wird in der organischen Chemie eine Atomgruppe (Organyl-Rest oder sonstiger Rest) bezeichnet, welche in einem Molekül ein Wasserstoffatom ersetzt (Hier die Methylgruppen).

Der Einsatz von Sauerstoff als Reaktivgas für die Schichtabscheidung einer chemisch beständigen Passivierungsschicht muss daher begrenzt oder sogar vermieden werden. Zur Erzeugung oxidischer $SiO_x$-Schichten (Barriereschicht) ist die Beimischung einer großen Menge von Sauerstoff allerdings zwingend notwendig. Eine Erzeugung beider funktionaler Schichten nur über die Kontrolle der eingebrachten Energie (z.B. über die Pulsparameter der Plasmaanregung) während des Prozesses ist daher unzureichend.

Die Erfindung betrifft sowohl die Beschichtung gemäß Anspruch 10 als auch das Verfahren zur Herstellung der Beschichtung gemäß Anspruch 1.

Ein erster Aspekt der Erfindung besteht darin, für die Beschichtung eines Kunststoffbehälters für aggressive Medien (z.B. Laugen) eine durch PECVD abgeschiedene Gradientenschicht mit zumindest einer oxidisch geprägten Barrierezone und einer organisch geprägten Passivierungszone einzusetzen. Die Gradientenschicht setzt sich auf Nanoebene aus einer Vielzahl von Nanolagen mit einer Auflösung weniger Nanometer (bis zu 1 Nanometer) zusammen, deren stoffliche Zusammensetzung sich von Nanolage zu Nanolage graduell verändert. Entlang der Schichtdicke ändert sich die Prägung der stofflichen Zusammensetzung graduell von organisch zu oxidisch oder umgekehrt. Innerhalb einer Nanolage ist die stoffliche Zusammensetzung der Schicht im Wesentlichen homogen. Die stoffliche Zusammensetzung der einzelnen Nanolagen wird durch die Prozessführung des PECVD-Verfahrens bestimmt.

Die Barrierezone ist oxidisch geprägt und bietet eine hohe Barriereleistung, um eine Permeation von Gasen durch die Behälterwandung zu vermeiden. Vorzugsweise weist die Barrierezone eine hohe Konzentration an Si-O-Si Verbindungen auf.

Die Passivierungszone ist organisch geprägt und bietet eine hohe Beständigkeit gegen aggressive Medien, insbesondere alkalische Medien. Die Passivierungszone ist bevorzugt auf einer Barrierezone angeordnet und schützt die Barrierezone vor Umgebungseinwirkungen, insbesondere vor aggressiven Medien innerhalb des Behälters. Bevorzugt weist die Passivierungszone eine hohe Konzentration an organischen Verbindungen, vorzugsweise $CH_3$- und/oder $CH_2$-Verbindungen, und eine geringe Konzentration an oxidischen Verbindungen, insbesondere geringe Konzentration an Si-OH- und Si-O-Si-Verbindungen, auf.

Je nach Art des Kunststoffsubstrats, auf das die Beschichtung angewendet werden soll, ist es vorteilhaft zwischen dem Kunststoffsubstrat und der oxidischen Barrierezone eine organisch geprägte Haftzone abzuscheiden.

Auf Polyolefinen wird in der Regel eine Beschichtung mit Haftzone angewendet. Auf bestimmten Kunststoffen, z.B. **PET,** kann auf die Haftzone verzichtet werden.

Die Gradientenschicht umfasst in einer ersten Ausführungsform zumindest eine oxidische Barrierezone und eine organische Passivierungszone (2-Zonen-Schicht). **In** einer weiteren Ausführungsform umfasst die Gradientenschicht eine organische Haftzone, eine oxidische Barrierezone und eine organische Passivierungszone (3-Zonen-Schicht).

Die verschiedenen Zonen gehen graduell ineinander über. Die Zonen bilden eine zusammenhängende Gradientenschicht mit fließenden Übergängen zwischen den Zonen. Die Zonen haben vorzugsweise eine oxidische bzw. organische Schwerpunktlage, die entweder im mittleren Bereich der Zone oder im Randbereich der Zone liegt, je nachdem, ob es sich um eine Randzone der Gradientenschicht oder eine Zone innerhalb der Gradientenschicht handelt. **In** bestimmten Ausführungsformen kann die Beschichtung mehrere Gradientenschichten umfassen. Die Gradientenschicht kann auch mehrere Zonen desselben Typs (Passivierungszone, Barrierezone oder Haftzone) umfassen.

Ein besonderer Vorteil der Gradientenschicht gegenüber Verbundschichten ist, dass die Schichten besonders homogen, d.h. porenfrei und mit geringen Eigenspannungen, ausgebildet werden können. Während der Abscheidung der einzelnen Nanolagen treffen stets chemisch ähnliche Nanolagen aufeinander, wodurch Inselwachstum vermieden werden kann.

Die graduell ineinander übergehenden Zonen lassen sich auf unterschiedliche Weise voneinander abgrenzen. Vorzugsweise grenzt man die Zonen anhand des Anteils organischer bzw. oxidischer Verbindungen voneinander ab. Die Gradientenschicht ist aus einer Vielzahl (ca. 80 - 1000) von Nanolagen mit einer Dicke weniger Nanometer aufgebaut. Überwiegt der Anteil oxidischer Verbindungen in einer Nanolage, kann diese Nanolage der Barrierezone zugerechnet werden. Überwiegen die organischen Verbindungen in einer Nanolage, kann diese der Passivierungs- oder der Haftzone zugeordnet werden.

Ein weiterer Aspekt der Erfindung besteht darin, die Konzentration des eingesetzten Reaktivgases, bevorzugt Sauerstoff, während der Abscheidung der Gradientenschicht zu variieren, um einen ausreichend starken Gradienten zwischen oxidischer Barrierezone und organischer Passivierungszone bzw. Haftzone zu erreichen.

Zur Abscheidung der Gradientenschicht im PECVD-Verfahren wird ein Prozessgasgemisch in einen zuvor evakuierten Reaktionsraum geführt, in dem das Kunststoffsubstrat angeordnet ist. Das Prozessgasgemisch umfasst einen oder mehrere siliziumhaltige Präkursoren, vorzugsweise Hexamethyldisiloxan (HMDSO) und/oder Hexamethyldisilazan (HMDSN). Das Prozessgasgemisch umfasst außerdem zumindest zeitweise ein oder mehrere Reaktivgase, vorzugsweise Sauerstoff. In bestimmten Ausführungsformen können weitere Hilfsgase, z.B. Edelgase zugeführt werden.

Die Zusammensetzung, d.h. das Mischverhältnis, des Prozessgasgemischs ist dynamisch einstellbar, vorzugsweise mittels Massflussreglern. Insbesondere ist der Reaktivgas-Massefluss, der Präkursor-Massefluss, sowie das Verhältnis der beiden Masseflüsse zueinander regelbar. **In** bestimmten Ausführungsformen können mehrere Präkursoren und/oder Reaktivgase eingesetzt werden. **In** diesen Fällen ist auch der Anteil der einzelnen Präkursor-Masseflüsse untereinander regelbar. Vorzugsweise wird das Verhältnis zwischen Reaktivgas-Massefluss und Präkursor-Massefluss geregelt.

Der Reaktivgasanteil C kann insbesondere durch die folgende Formel beschrieben werden:

$$C = \frac{RGF}{PGF}$$

C:  Reaktivgasanteil
RGF:  Reaktivgas-Massefluss
PGF:  Präkursor-Massefluss

Der Präkursor-Massefluss kann sich aus der Summe der Masseflüsse mehrerer Präkursoren ergeben.

Eine Erhöhung der Reaktivgasbeimischung, insbesondere der Sauerstoffbeimischung, zum Prozess, d.h. eine Erhöhung des Reaktivgasanteils C, bedingt einen höheren Fragmentierungsgrad von siliziumhaltigen Monomeren sowie eine stärkere Oxidation der abgeschiedenen Schichten. Die Oxidation der Schichten wiederum korreliert mit der Barrierewirkung, bzw. der Hydrolysestabilität der Schichten.

Durch die Steuerung des Reaktivgasanteils, vorzugsweise des Sauerstoffanteils, kann die stoffliche Zusammensetzung und damit die Funktion der abgeschiedenen Nanolagen in einem breiteren Spektrum gesteuert werden. Auf diese Weise lassen sich eine hohe Barrierewirkung und eine starke Passivierung bei zugleich homogenem, d.h. porenfreiem, Schichtaufbau erreichen.

Ein weiterer Aspekt der Erfindung besteht darin, die Anregungsenergie während der Abscheidung der Gradientenschicht gezielt in Bezug auf die an der Reaktion beteiligten Prozessgase zu steuern. Insbesondere wird die Anregungsenergie massebezogen in Abhängigkeit der Zusammensetzung des Prozessgasgemischs geregelt. Die gezielte Einstellung der massebezogenen Anregungsenergie verhindert Volumenpolymerisation, wodurch ebenfalls Porenbildung verhindert werden kann.

Bei der plasmaunterstützten chemischen Gasphasenabscheidung wird das Prozessgasgemisch durch eine Energiequelle zu einem Plasma angeregt. Als Energiequelle wird vorzugsweise ein Magnetron eingesetzt. Die Anregung findet vorzugsweise durch Mikrowellen statt. Vorzugsweise wird das Plasma gepulst angeregt. Durch die gepulste Anregung kann eine zu starke Erhitzung des Kunststoffsubstrats durch das Plasma verhindert werden.

Durch die Plasmaanregung wird der Reaktion der Prozessgase Energie zugeführt. Die massebezogene Anregungsenergie beschreibt die Energie, die der Reaktion pro Teilchenmasse zugeführt wird. Durch gezielte Einstellung der pro Teilchenmasse zugeführten Energie lässt sich eine besonders homogene Schichtabscheidung erreichen.

Es hat sich gezeigt, dass sich vollständig porenfreie Schichten abscheiden lassen, wenn die der Reaktion zugeführte Anregungsenergie in Abhängigkeit der Prozessgasmischung geregelt wird. Vorzugsweise wird die massebezogene Anregungsenergie in den jeweiligen Zonen der Gradientenschicht in einem bestimmten Prozessfenster in Abhängigkeit des jeweiligen Reaktivgasanteils eingestellt.

Zur Berechnung der massebezogenen Anregungsenergie ist es vorteilhaft, den Massefluss der an der Reaktion beteiligten Prozessgase mit einem Korrekturfaktor zur Berücksichtigung der Reaktivität des Reaktivgases zu korrigieren. Der Korrekturfaktor für Sauerstoff beträgt K = 0,6 und für Stickstoff K = 0,5.

Die massebezogene Anregungsenergie, auch Energiedichte genannt, lässt sich mit folgender Formel beschreiben:

$$E = \frac{Pp}{Fc} = \frac{P \times \frac{ton}{ton+toff}}{PGF + K \times RGF} \; [Jkg^{-1}]$$

E:  massebezogene Anregungsenergie (Energiedichte) [J/kg]
$P_p$:  mittlere Pulsleistung [J/s]
$F_c$:  korrigierter Prozessgasfluss [kg/s]
P:  Leistung [J/s]
$t_{on}$:  Pulsanschaltzeit [s]
$t_{off}$:  Pulsausschaltzeit [s]
PGF:  Präkursor-Massefluss [kg/s]
RGF:  Reaktivgas-Massefluss [kg/s]

In der bevorzugten Ausführungsform wird zur Abscheidung der Barrierezone bei relativ hohem Reaktivgasanteil, vorzugsweise mit $25 \leq C \leq 250$, besonders bevorzugt mit $50 \leq C \leq 100$, eine relativ hohe massebezogene Anregungsenergie zugeführt, vorzugsweise 400 kJ/kg $\leq$ E $\leq$ 2700 kJ/kg, besonders bevorzugt 1800 kJ/kg $\leq$ E $\leq$ 2200 kJ/kg.

Zur Abscheidung der Passivierungszone wird bei relativ niedrigem Reaktivgasanteil, vorzugsweise $0 \leq C \leq 20$, besonders bevorzugt $0 \leq C \leq 10$, eine relativ niedrige bis mittlere massebezogene Anregungsenergie zugeführt, vorzugsweise 30 kJ/kg $\leq$ E $\leq$ 1700 kJ/kg, besonders bevorzugt 500 kJ/kg $\leq$ E $\leq$ 800 kJ/kg.

Zur Abscheidung der optionalen Haftzone wird bei relativ niedrigem bis mittleren Reaktivgasanteil, vorzugsweise $0 \leq C \leq 50$, besonders bevorzugt $0 \leq C \leq 30$, eine relativ niedrige massebezogene Anregungsenergie zugeführt, vorzugsweise 20 kJ/kg $\leq$ E $\leq$ 200 kJ/kg, besonders bevorzugt 30 kJ/kg $\leq$ E $\leq$ 140 kJ/kg.

Die hier genannten Intervallgrenzen sind sowohl in Kombination als auch jeweils für sich allein genommen offenbart und tragen zum technischen Effekt der Erfindung bei. So ist ausdrücklich auch die jeweils untere oder obere Grenze des Intervalls eigenständig offenbart.

Ein weiterer Aspekt der Erfindung besteht darin, die Gradientenschicht, insbesondere die einzelnen Zonen, ausreichend dünn auszubilden. Die Gesamtdicke der Beschichtung liegt vorteilhafterweise unter 1000 Nanometer. Vorzugsweise ist die Beschichtung bis zu 500 Nanometer dick.

Eine dünne Beschichtung weist eine geringere Schichtspannung auf. Durch die geringere Schichtspannung wird das Risiko gesenkt, dass sich bei mechanischer Belastung Risse in der Beschichtung bilden oder die Beschichtung bricht. Im Gegensatz zu dickeren Gradientenschichten im Bereich der Kratzschutzschichten (z.B. für Brillengläser) sind die Anforderungen in Bezug auf die mechanische Belastbarkeit im Bereich der Kunststoffbehälter höher. Dünnwandige Kunststoffbehälter sind in der Regel weich. Bei der Lagerung oder dem Transport der Behälter kann es zu Verformungen des Behälters (z.B. bei Stößen oder beim Stapeln) kommen. Solche Verformungen dürfen nicht zum Versagen der Beschichtung führen. Es zeigt sich, dass dünne Beschichtungen mit einer Dicke unter 1000 Nanometer, vorzugsweise unter 500 Nanometer, besonders gut für Kunststoffbehälter, insbesondere zur Lagerung aggressiver Medien, geeignet sind.

Auch die in der Gradientenschicht gebildeten Zonen weisen vorzugsweise eine für deren Funktion und/oder den Schichtbildungsprozess optimierte Dicke auf.

Die Dicke der optionalen Haftzone beträgt vorzugsweise maximal 10 Nanometer. Die Haftzone ist vorzugsweise dünner als die Barrierezone oder die Passivierungszone. Eine derart dünne Haftzone reicht aus, um das Kunststoffsubstrat vor dem oxidativ degradativen Einfluss des sauerstoffreichen Plasmas zur Abscheidung der Barrierezone zu schützen. Bei steigender Dicke der Haftzone kann es bei der Abscheidung der darauffolgenden Barrierezone zu verstärkter Porenbildung kommen. Eine dünne Haftzone von maximal 10 Nanometer Dicke ist daher vorteilhaft für eine homogene Schichtbildung. Eine solch dünne Haftzone bildet eine möglichst homogene Grundlage zur Abscheidung der darauffolgenden Barrierezone.

Die Barrierezone hat vorzugsweise eine maximale Dicke von 100 Nanometer. Die dünne Barrierezone reicht aus, um eine ausreichende Migrationsbarriere zu bilden. Gleichzeitig ist ein homogenes Schichtwachstum möglich. Vorzugsweise ist die Barrierezone dünner als die Passivierungszone ausgebildet. Eine dünnere Barrierezone ist vorteilhaft für ein rissfreies Schichtwachstum.

Hochoxidierte Schichten wachsen mit intrinsischen Schichtspannungen auf. Die organisch geprägte Passivierungsschicht wächst hingegen nahezu frei von Schichtspannungen und kann daher auch dicker ausgebildet sein.

Die Passivierungszone hat eine bevorzugte Dicke von bis zu 800 Nanometer. Da die Passivierungszone einen ausreichenden Schutz der Barrierezone vor dem Einfluss der aggressiven Medien im Behälter gewährleisten muss, kann die Passivierungszone dicker ausgebildet werden als die Barrierezone.

Die Beschichtung kann aus einer oder mehreren Gradientenschichten aufgebaut werden. Der oben beschriebene Aufbau der Gradientenschicht kann zur Verstärkung der Schutzwirkung in mehreren zusammenhängenden Gradientenschichten wiederholt werden. Eine am Rand der Beschichtung liegende Zone hat ihren organischen bzw. oxidischen Schwerpunkt in der Regel am äußeren, d.h. dem Medium bzw. dem Substrat zugewandten, Ende. Eine im Inneren einer Gradientenschicht angeordnete Zone hat in der Regel einen mittig liegenden oxidischen bzw. organischen Schwerpunkt.

Im Gegensatz zum konsekutiven Auftrag verschiedener Schichttypen in einer Verbundschicht findet das Beschichtungsmaterial bei einer Gradientenschicht immer eine chemisch ähnliche Oberfläche vor, sodass Lagenwachstum begünstigt und die Ausbildung von Poren an zusammenwachsenden Inseln verhindert wird.

Die Anpassung der Gasflüsse, d.h. die Zusammensetzung des Prozessgasgemischs, erlaubt die Einstellung der benötigten chemischen Zusammensetzung von Barriere- und Passivierungszonen. Durch die gezielte Kontrolle der pro Molekül eingebrachten Energie in Abhängigkeit vom Prozessgasgemisch wird weiterhin Volumenpolymerisation unterbunden, um zu verhindern, dass große Oligomere an der Schichtbildung teilnehmen und Poren erzeugen können.

Mithilfe des erfindungsgemäßen Verfahrens lassen sich somit Schichten erzeugen, die über eine hohe Barriereleistung gegen Gase und andere Permeanten und gleichzeitig über eine hohe Stabilität gegen aggressive Medien oder andere Umwelteinflüsse verfügen, da die oberen Schichten chemisch stabil und zugleich porenfrei sind.

Für mit den Gradientenschichten beschichtete Behälter aus Polyethylen können in Abhängigkeit von Oberflächengüte, Volumen und Gewicht der Behälter Barriereverbesserungen von Faktor 50 bis 2000, bezogen auf die Sauerstoffpermeationsrate, erzielt werden. Ferner bleiben die Gradientenschichten auch nach längerer Lagerung von hochalkalischer NaOH-Lösung oder ähnlicher aggressiver Chemikalien beständig und die Barriere bleibt erhalten. Damit können sie dazu eingesetzt werden, Verpackungen aus klassischen Verpackungskunststoffen wie PE oder PET zur Lagerung sensibler Chemikalien einsetzbar zu machen.

Anstelle von Silizium sind für den Einsatz der Erfindung auch andere geeignete Halbmetalle oder Metalle denkbar. Die Erfindung ist nicht auf siliziumbasierte Ausgangsstoffe bzw. Beschichtungen beschränkt. Alternativ oder zusätzlich zu den bevorzugten Präkursoren HMDSO und HMDSN können auch andere (halb-)metallische Monomere eingesetzt werden. Auch können alternativ oder zusätzlich zu Sauerstoff andere Reaktivgase, z.B. Stickstoff, eingesetzt werden. Die Offenbarung umfasst auch solche Ausführungsformen, in denen anstatt der bevorzugten Prozessgase, die hier genannten oder dem Fachmann für PECVD bekannten Alternativen eingesetzt werden.

Weitere vorteilhafte Ausführungsformen werden nachfolgend anhand der Zeichnungen beschrieben.

Die Erfindung ist in den Zeichnungen beispielhaft und schematisch dargestellt. Es zeigen:

Figur 1: Aufbau eines Reaktors;

Figur 2: Aufbau einer Gradientenschicht (3-Zonen-Schicht);

Figur 3: Aufbau einer Beschichtung mit mehreren Gradientenschichten;

Figur 4: Vorteilhafter Verlauf der Prozessparameter C und E während der Abscheidung einer Gradientschicht;

Figur 5: FT-IR Spektren an den Schwerpunkten einer Haftzone (EH) und einer Barrierezone (WB);

Figur 6:     FT-IR Spektren am Schwerpunkt einer Passivierungszone.

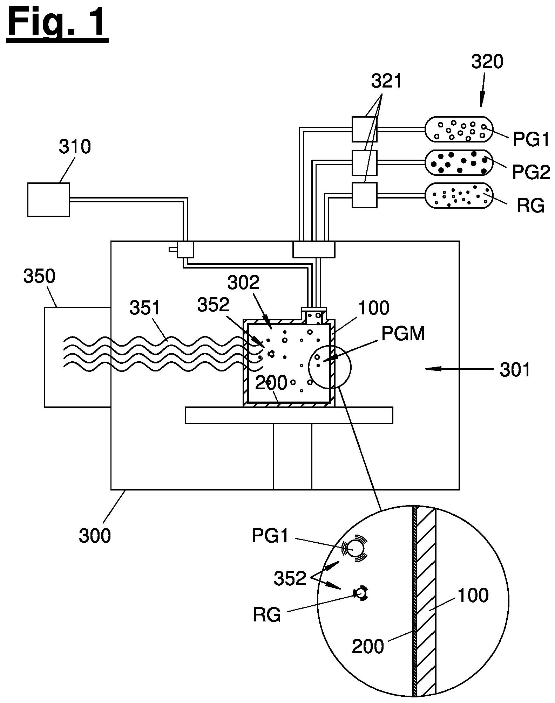

Figur 1 zeigt einen schematischen Aufbau eines Reaktors (300). Der Reaktor (300) umfasst eine Prozesskammer (301). Das Substrat (100) wird in der Prozesskammer (301) angeordnet. In oder an dem Kunststoffsubstrat (100) wird ein Reaktionsraum (302) gebildet. Der Reaktionsraum (302) kann mit einer Pumpe (310) evakuiert werden. In der gezeigten Ausführungsform wird der Reaktionsraum im Inneren des Behälters (100) gebildet, um die Innenseite des Kunststoffbehälters (100), z.B. eines Kanisters, zu beschichten.

Über Leitungen wird ein Prozessgasgemisch (PGM) in den Reaktionsraum (302) geführt. Der Reaktor umfasst eine Gasversorgung (320) sowie einen oder mehrere Gasflussregler (321), vorzugsweise Masseflussregler. Das Prozessgasgemisch (PGM) setzt sich aus einem oder mehreren Prozessgasen (PG1, PG2, RG) zusammen, deren Mischverhältnisse geregelt werden können.

In der bevorzugten Ausführungsform werden zwei Präkursoren eingesetzt. Der erste Präkursor (PG1) ist vorzugsweise HMDSN. Der zweite Präkursor (PG2) ist vorzugsweise HDMSO.

Ein oder mehrere Präkursoren (PG1, PG2) können insbesondere für eine bestimmte Zone der Gradientenschicht eingesetzt werden. Es ist insbesondere vorteilhaft für die Abscheidung der Haftzone (201) und/oder der Passivierungszone (203) (überwiegend) HMDSO als einen ersten Präkursor einzusetzen. Alternativ oder zusätzlich ist es besonders vorteilhaft für die Abscheidung der Barrierezone (202) (überwiegend) HMDSN als zweiten Präkursor einzusetzen.

Insbesondere im Übergang zwischen zwei Zonen der Gradientenschicht können zumindest vorrübergehend zwei oder mehr Präkursoren gemischt werden.

Der Präkursormassefluss ist vorzugsweise auf die Summe der Masseflüsse der mehreren Präkursoren bezogen. Bei chemisch ähnlichen Präkursoren (z.B. HMDSN und HMDSO) können die Masseflüsse der einzelnen Präkursoren im Prozessgasgemisch für die Bestimmung der massebezogenen Anregungsenergie zu einem rechnerischen Präkursormassefluss zusammengefasst werden. In manchen Ausführungsformen kann es zweckmäßig sein, die einzelnen Gasmasseflüsse mit einem Faktor zu gewichten.

Als Reaktivgas (RG) wird vorzugsweise Sauerstoff eingesetzt. Alternativ oder zusätzlich kann Stickstoff als (weiteres) Reaktivgas (RG) eingesetzt werden.

Im Reaktionsraum (302) wird das Prozessgasgemisch (PGM) mittels einer Energiequelle (350) angeregt. Vorzugsweise wird als Energiequelle (350) ein Magnetron eingesetzt. Die Anregung der Plasmas erfolgt vorzugsweise durch gepulste Mikrowellen (351). Alternativ oder zusätzlich können auch ICP-Plasmen eingesetzt werden.

Aus dem zum Plasma (352) angeregten Prozessgasgemisch wird die Beschichtung (200) auf dem Kunststoffbehälter (100) abgeschieden.

Die Prozesskammer (301) kann einen oder mehrere Reaktionsräume (302) umfassen. Der Reaktionsraum (302) kann die gesamte Prozesskammer oder nur einen Teil beanspruchen. Insbesondere kann der Reaktionsraum (302) im Inneren des Kunststoffbehälters (100) gebildet werden. Vorzugsweise ist der Behälter abgedichtet. Alternativ oder zusätzlich kann ein weiterer Reaktionsraum, z.B. an der Außenseite des Behälters, gebildet werden.

Der Reaktor (300) kann auch mehrere Prozesskammern (301) mit einem oder mehreren Reaktionsräumen (302) umfassen.

Die Abscheidung der Beschichtung (200) erfolgt je nach Aufbau der Schicht, Größe des Substrats (100) und Prozessführung vorzugsweise über einen Zeitraum von ca. 5 - 60 Sekunden. Bei besonders großen Behältern kann es auch zu längeren Prozesszeiten kommen. Während des Abscheideprozesses wird mindestens eine Gradientenschicht abgeschieden. Während des Verfahrens wird das Mischverhältnis des Prozessgasgemischs (PGM) verändert. Insbesondere wird der Masseflussanteil der Präkursoren (PG1, PG2) und/oder des Reaktivgases (RG) verändert. Durch die Variation der Prozessgase wird die stoffliche Zusammensetzung der Beschichtung (200) beeinflusst.

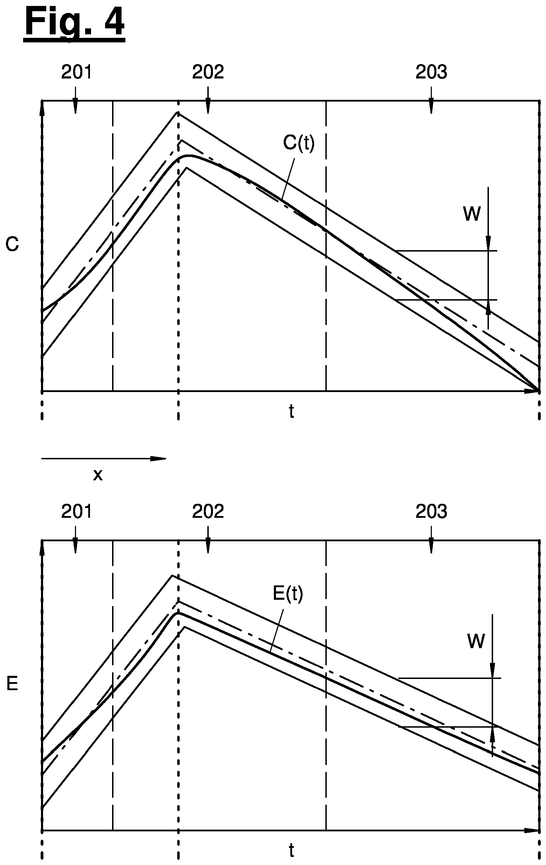

Ein vorteilhafter Verlauf der Prozessparameter ist in Figur 4 dargestellt.

Vorzugsweise wird der Reaktivgasanteil (C) und/oder die massebezogene Anregungsenergie (E) zwischen der Haftzone (201) und der Barrierezone (202) in Schichtaufbaurichtung (x) graduell erhöht.

Erfindungsgemäß wird die massebezogene Anregungsenergie (E) zwischen der Barrierezone (202) und der Passivierungszone (203) in Schichtaufbaurichtung (x) graduell gesenkt. Die Variation des Reaktivgasanteils (C) und der massebezogenen Anregungsenergie (E) erfolgt vorzugsweise gleichmäßig, insbesondere stufenlos.

Besonders vorteilhafterweise wird die Anregungsenergie (E) in Abhängigkeit der Zusammensetzung des Prozessgasgemischs (PGM), insbesondere in Abhängigkeit des Präkursorgasmasseflusses und/oder des Reaktivgasmasseflusses, gesteuert.

Zur Steuerung der massebezogenen Anregungsenergie stehen dem Fachmann mehrere Möglichkeiten zur Verfügung. Insbesondere kann die mittlere Pulsleistung eingestellt werden. Vorteilhafterweise werden die Leistung der Energiequelle und/oder die Pulsparameter geregelt. Es ist insbesondere vorteilhaft einen Sollwert für die massebezogene Anregungsenergie (E) zu berechnen und diese mit einer oder mehreren Stellgrößen, z.B. eine Auswahl oder Kombination aus (Nenn-)Leistungszufuhr, Pulsanschaltzeit, Pulsausschaltzeit oder Pulsrate, zu steuern oder zu regeln.

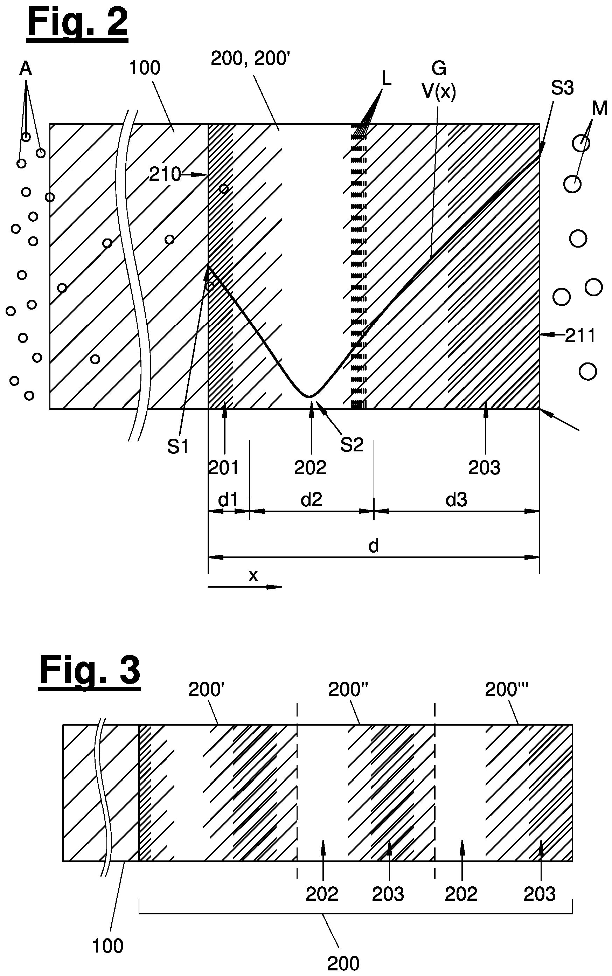

Figur 2 zeigt einen schematischen Aufbau einer Beschichtung (200) mit einer Gradientenschicht (200') als 3-Zonen-Schicht. Die Beschichtung (200) wird auf dem Kunststoffsubstrat (100) abgeschieden. Die Abscheidung, d.h. der Aufbau in Nanolagen (L), der Beschichtung erfolgt in Schichtaufbaurichtung (x).

Die Dicke einer geeigneten Beschichtung (d) liegt vorzugsweise im Bereich zwischen 80 - 1000 Nanometer. Das Kunststoffsubstrat (100) ist um mehrere Größenordnungen dicker. Übliche Wandstärken für Kunststoffbehälter liegen im Millimeter-Bereich. Zur gemeinsamen Darstellbarkeit ist das Kunststoffsubstrat daher gebrochen dargestellt.

Bei einer 3-Zonen-Schicht (Fig. 2) wird auf dem Substrat (100) zuerst eine organisch geprägte Haftzone (201) abgeschieden. Anschließend wird auf der Haftzone (201) eine oxidisch geprägte Barrierezone (202) abgeschieden, wobei die Zonen fließend ineinander übergehen. Auf der Barrierezone (202) wird eine organisch geprägte Passivierungszone (203) abgeschieden.

Bei einer 2-Zonen-Schicht kann die Barrierezone (202) auch direkt auf dem Substrat abgeschieden werden.

Die Gradientenschicht (200') umfasst zumindest eine Barrierezone (202) und eine Passivierungszone (203). Die Passivierungszone (203) ist zwischen der Umgebungsseite (211) der Beschichtung (200) und der Barrierezone (202) angeordnet. Die Passivierungszone (203) schützt die Barrierezone (202). Die Passivierungszone ist beständig gegen den Einfluss aggressiver Medien (M).

Die Beschichtung (200) bildet eine Migrationsbarriere, d.h. auch Diffusionssperre, für Umgebungsgase (A), die durch das Kunststoffsubstrat (100) hindurch diffundieren können. Durch die Bildung einer oder mehrerer Barrierezonen (202) werden Permeationswege unterbrochen. Die oxidische Barrierezone (202) wirkt als Migrationsbarriere.

Die Gradientenschicht (200') wird während des Abscheideprozesses in einer Vielzahl von Nanolagen (L) aufgebaut. Die stoffliche Zusammensetzung der einzelnen Nanolagen (L) verändert sich in Schichtaufbaurichtung (x) graduell.

Der Gradient (G) zeigt schematisch den graduellen Verlauf der stofflichen Zusammensetzung der Gradientenschicht.

Die einzelnen Zonen, d.h. die Haftzone (201), die Barrierezone (202) und die Passivierungszone (203), lassen sich anhand deren stofflichen Zusammensetzung und des Anteils bestimmter Bindungstypen beschreiben. Repräsentativ für die sich graduell verändernde Zusammensetzung in einer bestimmten Zone kann der jeweilige Schwerpunkt der Zone betrachtet werden. Der jeweilige Schwerpunkt (S1, S2, S3) einer Zone kann als eine bestimmte Nanolage (L) an einem Extremum eines bestimmten Eigenschaftsverlaufs, z.B. des Gradienten (G), entlang der Schichtaufbaurichtung (x) betrachtet werden.

Die chemische Struktur der Gradientenschichten wird definiert durch die Extrema (Schwerpunkte), insbesondere lokale oder globale Maxima bzw. Minima, an denen sich die für den jeweiligen Schichttyp maximalen Schichteigenschaften eingestellt haben, sodass sich die Prozessführung fortan zur Erreichung des nächsten Extremums ausrichtet. Die chemische Struktur an den Extrempunkten (S1, S2, S3) wird im Folgenden näher beschrieben. Die Tabelle 1 gibt jeweils bevorzugte elementare Zusammensetzungen der Schichten an den Extrema an, die jeweils mittels Röntgenphotoelektronenspektroskopie (englisch: X-ray photoelectron spectroscopy, XPS) ermittelt wurden.

| Element<br>Schicht | C-1s [at%] | O-1s [at%] | Si 2p [at%] |
|---|---|---|---|
| Schwerpunkt Haftzone (201) | 44 | 35 | 21 |
| Schwerpunkt Barrierezone | 3 | 70 | 27 |
| Schwerpunkt Passivierungszone | 56 | 23 | 21 |

Tabelle 1: XPS-Daten zu den Extrema der stofflichen Zusammensetzung bei Nutzung von HMDSO und HMDSN als Präkursor

Um die chemische Struktur der verschiedenen Zonen, vor allem die der Schwerpunkte der jeweiligen Zonen, weiter zu charakterisieren, wird Fourier-Transform-Infrarotspektroskopie (FT-IR) eingesetzt. In Tabelle 2 sind die für die Auswertung der FTIR-Messungen wichtigen Vibrationsmodi aufgelistet.

Tabelle 2: Vibrationsmodus und FT-IR Peak-Position

| A | $b_{sym}$ CH3 | 1376 cm$^{-1}$ |
|---|---|---|

(fortgesetzt)

| | | |
|---|---|---|
| B | $s_{sym}$ CH3 | 1257 cm$^{-1}$ |
| C | Si-O-Si | 440 cm$^{-1}$<br>1010 - 1035 cm$^{-1}$<br>1070 cm$^{-1}$ |
| D | $s_{sym}$ Si-OH | 930 cm$^{-1}$ |
| E | r Si-CH$_3$, b Si(CH3)$_3$ | 839 cm$^{-1}$ |

In Tabelle 2 bezeichnen die Präfixe: s = stretching; b = bending; r = rocking; sowie das Subskript: sym = symmetrisch.

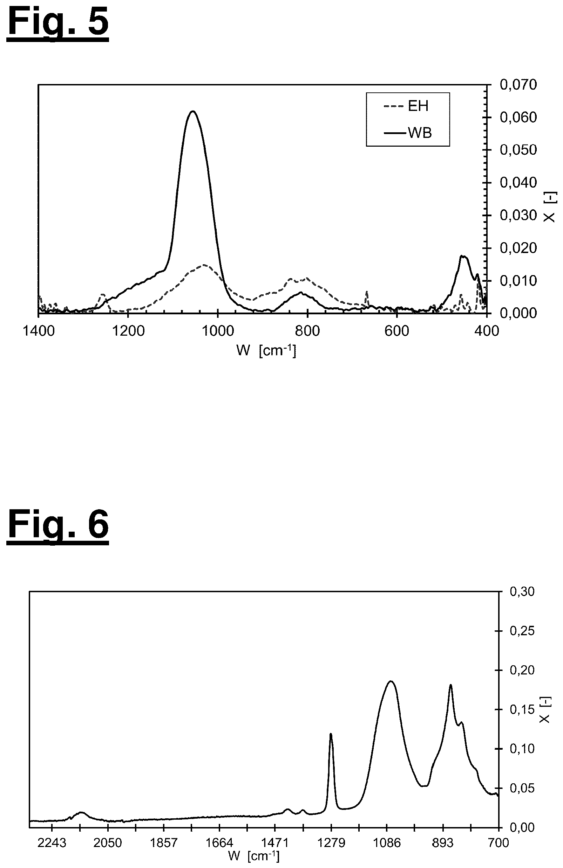

Figuren 5 und 6 zeigen exemplarische FT-IR Spektren der Extrema der jeweiligen Zonen. Der Parameter W bezeichnet die Wellenzahl mit der Einheit cm$^{-1}$ und der dimensionslose Parameter X bezeichnet die Extinktion.

Figur 5 zeigt FT-IR-Spektren an einem Schwerpunkt einer HMDSO-basierten Haftvermittlerzone (EH) und an einem Schwerpunkt einer HMDSN-basierten Barrierezone (WB).

Die Beschichtung am Extremum der Barrierezone (WB), vgl. Schwerpunkt S2 in Fig. 2, weist eine stark ausgeprägte Si-O-Si-Netzwerkstruktur auf (440 cm$^{-1}$ und 1070 cm$^{-1}$). Der breitbandige Peak zwischen 900 und 1.300 cm$^{-1}$ kann hauptsächlich drei anti-symmetrischen Si-O-Streckschwingungen in Si-O-Si-Verbindungen zugeordnet werden. Der Peak um 1135 cm$^{-1}$ kann einer Si-O-Si-Käfigstruktur mit Bindungswinkeln von etwa 150° zugeordnet werden. Netzwerkstrukturen mit Bindungswinkeln um 144° werden dem Peak um 1070 cm$^{-1}$ zugeordnet. Besitzen die Strukturen geringere Bindungswinkel als 144°, wird angenommen, dass sich Suboxide in den Netzwerken befinden (1010-1030 cm$^{-1}$). Der Peak bei 839 cm$^{-1}$ ist charakteristisch für Streckschwingungen und Schaukelschwingungen von Methylgruppen und zeigt, dass an einem Schwerpunkt der Haftvermittlerzone (EH) eine im Vergleich zu Barrierezone (WB) höhere Retention dieser funktionalen Gruppen aus dem Monomer erzielt wird, was dieser Zone einen organischen Charakter gibt.

Die Intensität und genaue Peak-Position des Peaks des Si-O-Si Netzwerks liefert Informationen über den Vernetzungsgrad der Schichten. Eine höhere Peak-Maximalposition zeigt eine höhere Si-O-Si-Vernetzung an. Eine solche Peakverschiebung ist im Vergleich der beiden Spektren deutlich zu erkennen. Bei der Barrierezone (WB) liegt eine hochvernetzte Beschichtung mit ausgeprägter Si-O-Si-Netzwerkstruktur vor, in welcher wenig C und C-H gebunden sind.

Figur 6 zeigt ein exemplarisches FT-IR Spektrum eines Schwerpunkts einer Passivierungszone. Die Abbildung zeigt das FT-IR-Spektrum einer HMDSO-basierten Passivierungszone (EP).

Das Spektrum der Passivierungszone in Figur 6 weist ähnlich wie das Spektrum der Haftzone (EH) in Figur 5 drei besonders ausgeprägte Peaks auf. Der Peak im Bereich von ca. 700 - 900 cm$^{-1}$ setzt sich aus der Überlagerung einer Reihe von Einzelpeaks zusammen. Der Peak bei der Wellenzahl von 1070 cm$^{-1}$ ist auch hier auf Streckschwingungen des Si-O-Si Netzwerks zurückzuführen. Der Peak bei 1257 cm$^{-1}$ ist charakteristisch für symmetrische Streckschwingungen von Methylgruppen.

Die chemische Struktur der Zonen ist vor allem in Bezug auf die Barriereleistung der Barrierezone sowie die Hydrolysestabilität der Passivierungszone von herausragender Bedeutung.

Zur Charakterisierung der chemischen Struktur der Zonen wird daher ferner der Strukturparameter V eingeführt, der das Verhältnis aus den Flächen (Gauß-Kurven) unter den mittels FT-IR gemessenen Peaks darstellt, die jeweils eindeutig CH$_3$- oder Si-O-Gruppen zugeordnet werden können (Die Zuordnung der Peaks kann Tabelle 2 entnommen werden):

$$V = \frac{A + B + E}{C + D}$$

V:  Strukturparameter [-]

A:  Extinktion X [-] an W = 1376 cm$^{-1}$

B:  Extinktion X [-] an W = 1257 cm$^{-1}$

E:  Extinktion X [-] an W = 839 cm$^{-1}$

C:  Extinktion X [-] an W = 440 cm$^{-1}$, 1010 cm$^{-1}$ bis 1035 cm$^{-1}$, 1070 cm$^{-1}$

D:  Extinktion X [-] an W = 930 cm$^{-1}$

Die Barriereleistung der Barrierezone wird hinsichtlich der chemischen Struktur vor allem vom Vernetzungs- und Oxidationsgrad der Schichten bestimmt. Für das Extremum der Barrierezone (WB) wurde ein vorteilhafter Bereich von V < 0,2 und ein besonders vorteilhafter Bereich von V < 0,05 bestimmt.

Die chemische Beständigkeit der Passivierungszone wird erklärt durch eine Betrachtung der Elektronegativität der beteiligten Elemente im Schichtmaterial, über die die lokalen Partialladungsverschiebungen der Bindungen bewertet werden kann. Je höher die Differenz der Elektronegativität der Bindungspartner ist, desto stärker sind die Bindungselektronen an den Bindungspartner mit höherer Elektronegativität lokalisiert. Dadurch erfährt dieses Element einen Elektronenschub.

Unter den in den Schichten vorhandenen Bindungen erfährt somit vor allem der Sauerstoff in Si-O den größten Elektronenschub. Dadurch tragen Sauerstoff negative ($\delta^-$) und das Silizium positive Partialladungen ($\delta^+$). Das Silizium erfährt also einen Elektronenmangel. Negativ geladene Ionen in Lösung greifen daher das mit Sauerstoff gebundene Silizium aufgrund dessen positiver Partialladungen an. Si-CH$_3$ Bindungen verfügen wiederum über geringe Partialladungen. Die Schicht wird also beispielsweise an Si-O vom Ion nukleophil angegriffen. Es resultieren Si-OH-Bindungen unter dem Bindungsbruch der Si-O-Si-Bindung. Innerhalb des Si-O Netzwerkes entstehen somit immer mehr Lücken unter Einbringung anionischer Endgruppen. Durch die CH$_3$-Gruppen werden schwache Bindungen sterisch abgeschirmt, was die Reaktion deutlich verlangsamt oder gänzlich aufhalten kann. Je größer das Verhältnis von CH$_3$-Gruppen zu Si-O ist, desto langsamer kann der Abbau der Schicht voranschreiten. Je größer V, desto beständiger die Beschichtung. Für das Extremum der Passivierungszone wird vorzugsweise mindestens ein Strukturparameter V > 0,20 und besonders vorteilhaft ein V > 0,35 erreicht, um die notwendige Schutzleistung bereitstellen zu können.

Zur Abscheidung einer vorteilhaften Haftvermittlerschicht wird am Extremum der Haftvermittlerzone (EH) ein Strukturparameter V von 0,1 < V < 0,3 erreicht.

Der Strukturparameter V kann zur Ermittlung der oxidischen bzw. organischen Schwerpunkte und/oder der funktionalen Zonen einer Gradientenschicht genutzt werden. In Figur 2 ist beispielsweise ein schematischer Verlauf des Strukturparameters V(x) entlang der Schichtaufbaurichtung x aufgetragen. Anhand der Extrema (S1, S2, S3) des Strukturparameters V(x) können die Schwerpunkte der Gradientenschicht und die einzelnen funktionalen Zonen einer Gradientenschicht ermittelt werden.

Der jeweilige oxidische bzw. organische Schwerpunkt einer Zone kann je nach Schichtarchitektur am Rand oder in der Mitte der Zone liegen. Die Übergänge zwischen den Zonen sind fließend.

Die Zonen werden vorzugsweise durch ihre stoffliche Zusammensetzung bestimmt. Die stoffliche Zusammensetzung der einzelnen Nanolagen bestimmt die Funktion der Schichtzonen.

Zur Abgrenzung der Zonen (201, 202, 203), z.B. der Bestimmung der Dicken (d1, d2, d3), können verschiedene Analysearten herangezogen werden. Beispielsweise kann die stoffliche Zusammensetzung der einzelnen Nanolagen im SIMS-Verfahren (Sekundärionen-Massenspektrometrie) oder ferner im nanoSIMS-Verfahren bestimmt werden. Durch Ionenbeschuss der Oberfläche können die Schichten in Nanometerauflösung abgetragen werden und analysiert werden.

Zur Definition der Dicke der Zonen kann der Strukturparameter V oder die elementare Zusammensetzung der Nanolagen entlang der Schichtaufbaurichtung ermittelt werden. Überwiegt der Anteil an organischen Verbindungen, kann die Lage der Passivierungs- bzw. Haftzone zugeordnet werden. Überwiegen oxidische Verbindungen kann die Lage der Barrierezone zugeordnet werden.

Die stoffliche Zusammensetzung zweier benachbarter Nanolagen (L) ist stets ähnlich. Durch die stoffliche Ähnlichkeit der einzelnen Nanolagen (L) wird ein homogenes Lagenwachstum begünstigt.

Der Vorteil des graduellen Aufbaus der Zonen der Gradientenschicht ist, dass während der Abscheidung jede Nanolage (L) eine chemisch ähnliche Grundlage findet. Die chemischen Eigenschaften der Nanolagen ändern sich nur allmählich. Hierdurch wird Inselwachstum verhindert.

Figur 3 zeigt einen beispielhaften Aufbau einer Beschichtung (200) mit mehreren Gradientenschichten (200', 200", 200‴). Der Aufbau der Gradientenschichten bzw. der einzelnen Zonen kann in Schichtaufbaurichtung wiederholt werden. Vorzugsweise gehen auch die Zonen zwischen zwei aufeinanderfolgenden Gradientenschichten (200', 200") graduell ineinander über.

Der mehrlagige Aufbau der Gradientenschichten kann insbesondere vorteilhaft sein, um die Migrationssperre und/oder die chemische Beständigkeit, d.h. den Schutz der Barrierezone, zu verstärken. Alternativ oder zusätzlich können dabei dennoch die geringen Dicken der einzelnen Zonen eingehalten werden, wodurch das homogene Lagenwachstum und die mechanischen Eigenschaften (z.B. niedrige Schichtspannungen) der Beschichtung begünstigt werden.

**In** einer nicht eigens dargestellten Ausführungsform kann die Beschichtung (200) auch eine Gradientenschicht (200‴) mit nur einer Barrierezone (202) und einer Passivierungszone (203) umfassen. Insbesondere für **PET-**Substrate kann die Haftzone (201) entfallen.

Bei einer 2-Zonen-Schicht (200‴) ist die Barrierezone (202) vorzugsweise direkt auf dem Kunststoffsubstrat (100) oder auf einer dazwischenliegenden Gradientenschicht (200', 200") angeordnet. Bei einer 2-Zonen-Schicht kann die Barrierezone (202) insbesondere einen am Rand der Zone liegenden oxidischen Schwerpunkt aufweisen.

Figur 4 zeigt einen vorteilhaften Verlauf des Reaktivgasanteils (C) bzw. der massebezogenen Anregungsenergie (E) während der Abscheidung einer Gradientenschicht (200') mit einer Haftzone (201), einer Barrierezone (202) und einer Passivierungszone (203).

Die Prozessgrößen C und E können insbesondere jeweils in einem bestimmten Prozessfenster (W) gesteuert oder geregelt werden.

Die Haftzone (201) wird mit einem geringen bis mittleren Reaktivgasanteil (C) abgeschieden. **In** einer vorteilhaften Ausführungsform wird zu Beginn des Prozesses ein zumindest geringer Sauerstoffanteil beigemischt. Durch das entstehende sauerstoffreiche Plasma wird die Oberfläche des Kunststoffsubstrats (210) aktiviert. Auf diese Weise kann eine vorhergehende Oberflächenaktivierung des Substrats (100) entfallen, wodurch die Prozesszeiten verkürzt werden können. Die Aktivierung der Oberfläche verbessert die Haftung der Beschichtung (200) auf der Substratoberfläche.

Die Haftzone (201) schützt empfindliche Kunststoffsubstrate (100), insbesondere Polyolefine, vor der oxidischen Barrierezone (202). Insofern hat die Haftzone (201) eine Schutzwirkung für das Kunststoffsubstrat.

Durch die graduelle Variation des Reaktivgasanteils (C) und/oder der massebezogenen Anregungsenergie (E) wird der Gradient (G) der stofflichen Zusammensetzung der abgeschiedenen Schicht gesteuert und ein homogenes und porenfreies Lagenwachstum begünstigt.

**In** bestimmten Phasen des Abscheidevorgangs kann der Anteil des (mindestens einen) Reaktivgases (RG) im Prozessgasgemisch zwischen 0 und 100 % liegen. Es kann zur Abscheidung eines stark oxidischen Bereichs zweckmäßig sein einen sehr hohen Reaktivgasanteil (C), vorzugsweise $50 \leq C \leq 100$, einzusetzen. Alternativ oder zusätzlich kann es zweckmäßig sein für einen organischen Bereich der Gradientenschicht einen niedrigen Reaktivgasanteil (C) oder gar kein Reaktivgas einzusetzen.

**In** einer besonders vorteilhaften Ausführungsform wird die Anregungsenergie (E) des Plasmas in Abhängigkeit der momentanen Prozessgaszusammensetzung gesteuert. Es ist besonders vorteilhaft die pro Teilchenmasse eingebrachte Energie in einem bestimmten Bereich zu halten und diesen Bereich dem veränderten Reaktivgasanteil anzupassen.

Durch die Veränderung des Reaktivgasanteils kann insbesondere eine hohe Bandbreite der stofflichen Zusammensetzungen zwischen den oxidischen und organischen Schwerpunkten der Gradientenschicht erreicht werden. Hierdurch können besonders starke Barrierewirkungen und Passivierungswirkungen erreicht werden, die eine ausreichende Migrationsbarriere und chemische Beständigkeit für Behälter aggressiver Medien ermöglichen.

Durch die Anpassung der massebezogenen Anregungsenergie (E) kann die Anregung und damit die Reaktion in einem für homogenes Schichtwachstum optimalen Bereich gehalten werden (trotz stark variierender Gaszusammensetzung). Hierdurch kann insbesondere Volumenpolymerisation vermieden werden. Dadurch wird eine porenfreie Schichtabscheidung möglich.

Die hier beschriebenen, dargestellten oder beanspruchten Ausführungsformen lassen sich in ihren einzelnen Merkmalen auch miteinander kombinieren. Merkmale können gegen einzelne Merkmale der übrigen Ausführungsformen ersetzt oder ergänzt werden.

## Bezugszeichenliste

| | | |
|---|---|---|
| 100 | Kunststoffsubstrat | plastic substrate |
| 200 | Beschichtung | coating |
| 200' | Gradientenschicht | coating layer |
| 201 | Kontaktzone | contact zone |
| 202 | Barrierezone | barrier zone |
| 203 | Passivierungszone | passivation zone |
| 210 | Substratseite, Substratoberfläche | substrate face |
| 211 | Umgebungsseite | environment face |
| | | |
| S1 | organischer Schwerpunkt | organic focal point |
| S2 | oxidischer Schwerpunkt | oxidic focal point |
| S3 | organischer Schwerpunkt | organic focal point |
| | | |
| 300 | Reaktor | reactor |
| 301 | Prozesskammer | process chamber |
| 302 | Reaktionsraum | reaction chamber |
| 310 | Pumpe | pump |
| 320 | Gasversorgung | gas supply |
| 321 | Gasflussregler | gas flow controller |
| 350 | Energiequelle, Magnetron | plasma source, magnetron |
| 351 | Mikrowellen | microwaves |

(fortgesetzt)

| | | |
|---|---|---|
| 352 | Plasma | plasma |
| PGM | Prozessgasgemisch | process gas mixture |
| PG | Präkursor, Polysiloxan | precursor, polysiloxane |
| PG1 | (Erster) Präkursor, HMDSN | (first) precursor |
| PG2 | (Zweiter) Präkursor, HMDSO | (second) precursor |
| RG | Reaktivgas, Sauerstoff | reactive gas, oxygen |
| A | Umgebungsgase | ambient gases |
| C | Reaktivgasanteil | reactive gas content |
| E | Anregungsenergie, massebezogen | excitation energy, mass-related |
| Fc | korrigierter Prozessgasfluss | corrected process gas flow |
| G | Gradient | gradient |
| K | Korrekturfaktor | correction factor |
| L | Nanolage | nano layer |
| M | Medium | medium |
| P | Leistungszufuhr | power supply |
| r | Auflösung | resolution |
| RGF | Reaktivgasmassefluss | reactive gas mass flow |
| PGF | Präkursormassefluss | precursor gas mass flow |
| ton | Pulsanschaltzeit | pulse on-time |
| toff | Pulsausschaltzeit | pulse off-time |
| W | Prozessfenster | process window |
| x | Schichtaufbaurichtung | layer buildup direction |

**Patentansprüche**

1. Verfahren zur Herstellung einer Beschichtung (200) zur Erzeugung einer chemisch beständigen Migrationssperre auf einem Kunststoffsubstrat (100), insbesondere einem Kunststoffbehälter, mittels plasmaunterstützter chemischer Gasphasenabscheidung (PECVD), wobei ein Prozessgasgemisch (PGM) in einen Reaktionsraum (302) geleitet wird und mittels einer Energiequelle (350) mit einer Anregungsenergie (E) zu einem Plasma (352) angeregt wird, wobei das Prozessgasgemisch (PGM) eine einstellbare Zusammensetzung aus einem oder mehreren Präkursoren (PG) und/oder einem oder mehreren Reaktivgasen (RG) aufweist, wobei auf dem Substrat (100) eine Gradientenschicht (200') mit einer Haftzone (201), einer Barrierezone (202) und einer Passivierungszone (203) oder eine Gradientenschicht (200") mit einer Barrierezone (202) und einer Passivierungszone (203) abgeschieden wird, **dadurch gekennzeichnet, dass** die Abscheidung der Gradientenschicht (200', 200") durch Variation des Reaktivgasanteils (C) im Prozessgasgemisch (PGM) gesteuert wird und die Anregungsenergie (E) massebezogen in Abhängigkeit des Präkursorgasmasseflusses und des Reaktivgasmasseflusses geregelt wird, wobei zur Abscheidung einer organisch geprägten Passivierungszone (203) auf einer oxidisch geprägten Barrierezone (202) die massebezogene Anregungsenergie (E) graduell gesenkt wird.

2. Verfahren nach Anspruch 1, wobei ein oder mehrere Pulsparameter der Energiequelle (350), insbesondere der Quotient aus der Pulseinschaltzeit und der Pulsausschaltzeit der Anregungspulse, zumindest zeitweise während der Abscheidung der Gradientenschicht, insbesondere während der Abscheidung der Haftzone (201) und/oder der Barrierezone (202), konstant gehalten werden.

3. Verfahren nach Anspruch 1 oder 2, wobei der Reaktivgasanteil (C) und/oder die massebezogene Anregungsenergie (E) zwischen der Haftzone (201) und der Barrierezone (202) in Schichtaufbaurichtung (x) graduell erhöht wird.

4. Verfahren nach einem der vorhergehenden Ansprüche, wobei der Reaktivgasanteil (C) zwischen der Barrierezone (202) und der Passivierungszone (203) in Schichtaufbaurichtung (x) graduell gesenkt wird.

5. Verfahren nach einem der vorhergehenden Ansprüche, wobei das Plasma durch gepulste Mikrowellen (351) angeregt wird.

6. Verfahren nach einem der vorhergehenden Ansprüche, wobei zur Variation der Anregungsenergie (E) die Leistungszufuhr (P) und/oder die Pulsparameter, insbesondere die Pulsanschaltzeit (ton) und/oder die Pulsausschaltzeit (toff), die Pulsrate oder das Pulsverhältnis, der Plasmaanregung gesteuert wird.

7. Verfahren nach einem der vorhergehenden Ansprüche, wobei

   - während der Abscheidung der Barrierezone (202)

     - der Reaktivgasanteil (C) $25 \leq C \leq 250$, vorzugsweise

$$50 \leq C \leq 100,$$

     beträgt und/oder
     - die massebezogene Anregungsenergie (E)

$$400 \text{ kJ/kg} \leq E \leq 2700 \text{ kJ/kg},$$

     vorzugsweise

$$1800 \text{ kJ/kg} \leq E \leq 2200 \text{ kJ/kg},$$

     beträgt, und/oder

   - während der Abscheidung der Passivierungszone (203)

     - der Reaktivgasanteil (C) $0 \leq C \leq 20$, vorzugsweise

$$0 \leq C \leq 10,$$

     beträgt und/oder
     - die massebezogene Anregungsenergie (E)

$$30 \text{ kJ/kg} \leq E \leq 1700 \text{ kJ/kg},$$

     vorzugsweise

$$500 \text{ kJ/kg} \leq E \leq 800 \text{ kJ/kg},$$

     beträgt und/oder

   - während Abscheidung der Haftzone (201)

     - der Reaktivgasanteil (C) $0 \leq C \leq 50$, vorzugsweise

$$0 \leq C \leq 30,$$

     beträgt und/oder

- die massebezogene Anregungsenergie (E)

$$20 \text{ kJ/kg} \leq E \leq 200 \text{ kJ/kg},$$

vorzugsweise

$$30 \text{ kJ/kg} \leq E \leq 140 \text{ kJ/kg},$$

beträgt.

8. Verfahren nach einem der vorhergehenden Ansprüche, wobei das Prozessgasgemisch (PGM) einen oder mehrere siliziumhaltige Präkursoren (PG, PG1, PG2), insbesondere siliziumorganische Verbindungen, Siloxane, Silazane oder Silane, vorzugsweise Hexamethyldisiloxan (HMDSO) und/oder Hexamethyldisilazan (HMDSN), und/oder das Reaktivgas (RG) Sauerstoff umfasst.

9. Verfahren nach einem der vorhergehenden Ansprüche, wobei zur Abscheidung der Barrierezone (202) als Präkursor (PG1) Hexamethyldisilazan (HMDSN) und zur Abscheidung der Haftzone (201) und/oder der Passivierungszone (203) als Präkursor (PG2) Hexamethyldisiloxan (HMDSO) eingesetzt wird.

10. Beschichtung auf einem Kunststoffsubstrat (100), insbesondere für einen Kunststoffbehälter, zur Erzeugung einer chemisch beständigen Migrationssperre, wobei die Beschichtung (200) eine oder mehrere Gradientenschichten (200', 200", 200''') umfasst, wobei die mindestens eine Gradientenschicht siliziumorganische Verbindungen (SiO$_x$-C$_y$H$_z$) enthält, die aus einem oder mehreren siliziumhaltigen Präkursoren, insbesondere Siloxanen, Silazanen oder Silanen, abgeschieden wurden, wobei mindestens eine Gradientenschicht zumindest eine oxidisch geprägte Barrierezone (202) und eine organisch geprägte Passivierungszone (203) umfasst, wobei sich die chemische Zusammensetzung der Gradientenschicht ausgehend von der Substratseite der Beschichtung (210) in Schichtaufbaurichtung (x) graduell verändert und von mindestens einer Barrierezone (202) in eine Passivierungszone (203) übergeht, wobei die chemische Struktur der Gradientenschicht durch einen mit Fourier-Transform-Infrarotspektroskopie (FT-IR) messbaren Strukturparameter V

$$V = \frac{A + B + E}{C + D}$$

A: Extinktion an W = 1376 cm$^{-1}$
B: Extinktion an W = 1257 cm$^{-1}$
E: Extinktion an W = 839 cm$^{-1}$
C: Extinktion an W = 440 cm$^{-1}$, 1010 cm$^{-1}$ bis 1035 cm$^{-1}$, 1070 cm$^{-1}$
D: Extinktion an W = 930 cm$^{-1}$

ermittelbar ist, **dadurch gekennzeichnet, dass** der Strukturparameter V an seinem Maximum (S3) in der Passivierungszone (203) V > 0,2 beträgt.

11. Beschichtung nach Anspruch 10, wobei eine Gradientenschicht (200') zusätzlich mindestens eine organisch geprägte Haftzone (201) zwischen einer Barrierezone (202) und der Substratseite (210) umfasst.

12. Beschichtung nach Anspruch 10 oder 11, wobei der Strukturparameter V am Extremum (S2) der Barrierezone (201) kleiner als am Extremum (S3) der Passivierungszone (203) ist.

13. Beschichtung nach einem der vorhergehenden Ansprüche, wobei der Strukturparameter V am Extremum (S2) der Barrierezone (201) V < 0,2 beträgt, vorzugsweise V < 0,05 beträgt.

14. Beschichtung nach einem der vorhergehenden Ansprüche, wobei der Strukturparameter V am Extremum (S3) der Passivierungszone (203) V > 0,35 beträgt.

15. Beschichtung nach Anspruch 11, wobei der Strukturparameter V am Extremum (S1) der Haftzone (201) 0,1 < V < 0,3 beträgt.

**16.** Kunststoffbehälter mit einer Beschichtung nach einem der vorhergehenden Ansprüche.

**Claims**

**1.** Process for the production of a coating (200) for producing a chemically resistant migration barrier on a plastic substrate (100), in particular a plastic container, by means of plasma-enhanced chemical vapor deposition (PECVD) wherein a process gas mixture (PGM) is fed into a reaction space (302) and is excited by means of an energy source (350) with an excitation energy (E) to form a plasma (352), the process gas mixture (PGM) having an adjustable composition of one or more precursors (PG) and/or one or more reactive gases (RG), wherein a gradient coat (200') with an adhesion zone (201), a barrier zone (202) and a passivation zone (203) or a gradient coat (200") with a barrier zone (202) and a passivation zone (203) is deposited on the substrate (100),
**characterized in that** the deposition of the gradient coat (200', 200") is controlled by varying the reactive gas content (C) in the process gas mixture (PGM), wherein the excitation energy (E) is controlled on a mass-related basis as a function of the precursor gas mass flow and the reactive gas mass flow, the mass-related excitation energy (E) being gradually reduced for the deposition of an organically characterized passivation zone (203) on an oxidically characterized barrier zone (202).

**2.** Process according to claim 1, wherein one or more pulse parameters of the energy source (350), in particular the quotient of the pulse on-time and the pulse off-time of the excitation pulses, are kept constant at least temporarily during the deposition of the gradient coat, in particular during the deposition of the adhesion zone (201) and/or the barrier zone (202).

**3.** Process according to claim 1 or 2, wherein the reactive gas content (C) and/or the mass-related excitation energy (E) is gradually increased between the adhesion zone (201) and the barrier zone (202) along the layer build-up direction (x).

**4.** Process according to one of the preceding claims, wherein the reactive gas content (C) is gradually reduced between the barrier zone (202) and the passivation zone (203) along the layer build-up direction (x).

**5.** Process according to one of the preceding claims, wherein the plasma is excited by pulsed microwaves (351).

**6.** Process according to one of the preceding claims, wherein the power supply (P) and/or the pulse parameters, in particular the pulse on-time (ton) and/or the pulse off-time (toff), the pulse rate or the pulse ratio, of the plasma excitation is controlled in order to vary the excitation energy (E).

**7.** Process according to one of the preceding claims, wherein

    - during the deposition of the barrier zone (202)

        ■ the reactive gas content (C) is $25 \leq C \leq 250$, preferably $50 \leq C \leq 100$, and/or
        ■ the mass-related excitation energy (E) is 400 kJ/kg $\leq E \leq$ 2700 kJ/kg, preferably 1800 kJ/kg $\leq E \leq$ 2200 kJ/kg.

    - during the deposition of the passivation zone (203)

        ■ the reactive gas content (C) is $0 \leq C \leq 20$, preferably $0 \leq C \leq 10$, and/or
        ■ the mass-related excitation energy (E) is 30 kJ/kg $\leq E \leq$ 1700 kJ/kg, preferably 500 kJ/kg $\leq E \leq$ 800 kJ/kg.

    - during deposition of the adhesion zone (201)

        ■ the reactive gas content (C) is $0 \leq C \leq 50$, preferably $0 \leq C \leq 30$, and/or
        ■ the mass-related excitation energy (E) is 20 kJ/kg $\leq E \leq$ 200 kJ/kg, preferably 30 kJ/kg $\leq E \leq$ 140 kJ/kg.

**8.** Process according to one of the preceding claims, wherein the process gas mixture (PGM) comprises one or more silicon-containing precursors (PG, PG1, PG2), in particular organosilicon compounds, siloxanes, silazanes or silanes, preferably hexamethyldisiloxane (HMDSO) and/or hexamethyldisilazane (HMDSN), and/or the reactive gas (RG) comprises oxygen.

9. Process according to one of the preceding claims, wherein hexamethyldisilazane (HMDSN) is used as precursor (PG1) for depositing the barrier zone (202) and hexamethyldisiloxane (HMDSO) is used as precursor (PG2) for depositing the adhesion zone (201) and/or the passivation zone (203).

10. Coating on a plastic substrate (100), in particular for a plastic container, for producing a chemically resistant migration barrier, wherein the coating (200) comprises one or more gradient coats (200', 200'', 200'''), wherein the at least one gradient coat contains organosilicon compounds ($SiO_xC_yH_z$) which have been deposited from one or more silicon-containing precursors, in particular siloxanes, silazanes or silanes, wherein at least one gradient coat comprises at least one oxidically characterized barrier zone (202) and an organically characterized passivation zone (203), wherein the chemical configuration of the gradient coat changes gradually starting from the substrate face of the coating (210) along the layer build-up direction (x) and changes from at least one barrier zone (202) to a passivation zone (203), wherein the chemical structure of the gradient coat is determined by a structural parameter V which can be measured using Fourier-transform-infrared- spectroscopy (FT-IR):

$$V = \frac{A + B + E}{C + D}$$

A: Extinction at W = 1376 cm$^{-1}$
B: Extinction at W = 1257 cm$^{-1}$
E: Extinction at W = 839 cm$^{-1}$
C: Extinction at W = 440 cm$^{-1}$, 1010 cm$^{-1}$ to 1035 cm$^{-1}$, 1070 cm$^{-1}$
D: Extinction at W = 930 cm$^{-1}$,

**characterized in that** the structural parameter V at its maximum (S3) in the passivation zone (203) is V > 0.2.

11. Coating according to claim 10, wherein a gradient coat (200') additionally comprises at least one organically characterized adhesion zone (201) between a barrier zone (202) and the substrate face (210).

12. Coating according to claim 10 or 11, wherein the structural parameter V at the extremum (S2) of the barrier zone (201) is smaller than at the extremum (S3) of the passivation zone (203).

13. Coating according to one of the preceding claims, wherein the structural parameter V at the extremum (S2) of the barrier zone (201) is V < 0.2, preferably V < 0.05.

14. Coating according to one of the preceding claims, wherein the structural parameter V at the extremum (S3) of the passivation zone (203) is V > 0.35.

15. Coating according to claim 11, wherein the structural parameter V at the extremum (S1) of the adhesion zone (201) is 0.1 < V < 0.3.

16. Plastic container with a coating according to one of the preceding claims.

**Revendications**

1. Procédé pour la production d'un revêtement (200) destiné à la formation d'une barrière de migration chimiquement résistante sur un substrat en matière plastique (100), en particulier un récipient en matière plastique, par dépôt chimique en phase vapeur assisté par plasma (PECVD), dans lequel un mélange de gaz de processus (PGM) est envoyé dans une chambre de réaction (302) et est excité en un plasma (352) au moyen d'une source d'énergie (350) avec une énergie d'excitation (E), le mélange de gaz de processus (PGM) ayant une composition ajustable à base d'un ou de plusieurs précurseurs (PG) et/ou d'un ou de plusieurs gaz réactifs (RG), dans lequel une couche à gradient (200') comportant une zone d'adhérence (201), une zone barrière (202) et une zone de passivation (203), ou une couche à gradient (200'') comportant une zone barrière (202) et une zone de passivation (203) est déposée sur le substrat (100), **caractérisé en ce que** le dépôt de la couche à gradient (200', 200'') est commandé par variation de la proportion (C) de gaz réactif dans le mélange de gaz de processus (PGM) et l'énergie d'excitation (E) est réglée, par rapport à la masse, en fonction du débit massique de gaz précurseur et du débit massique de gaz réactif, l'énergie d'excitation (E) par rapport à la masse étant progressivement réduite pour le dépôt d'une zone de passivation (203) essentiellement organique sur une zone barrière (202) essentiellement de type oxyde.

**2.** Procédé selon la revendication 1, dans lequel un ou plusieurs paramètres d'impulsion de la source d'énergie (350), en particulier le quotient de la durée de mise en circuit d'impulsion et de la durée de mise hors circuit d'impulsion de l'impulsion d'excitation, est/sont maintenu(s) constant(s) au moins temporairement pendant le dépôt de la couche à gradient, en particulier pendant le dépôt de la zone d'adhérence (201) et/ou de la zone barrière (202).

**3.** Procédé selon la revendication 1 ou 2, dans lequel la proportion (C) de gaz réactif et/ou l'énergie d'excitation (E) par rapport à la masse entre la zone d'adhérence (201) et la zone barrière (202) est augmentée progressivement dans le sens d'accumulation (x) des couches.

**4.** Procédé selon l'une quelconque des revendications précédentes, dans lequel la proportion (C) de gaz réactif entre la zone barrière (202) et la zone de passivation (203) est progressivement réduite dans le sens d'accumulation (x) des couches (x).

**5.** Procédé selon l'une quelconque des revendications précédentes, dans lequel le plasma est excité par des micro-ondes pulsées (351).

**6.** Procédé selon l'une quelconque des revendications précédentes, dans lequel, pour la variation de l'énergie d'excitation (E), est/sont réglé(s) l'apport de puissance (P) et/ou les paramètres d'impulsion, en particulier la durée de mise en circuit d'impulsion (ton) et/ou la durée de mise hors circuit d'impulsion (toff), la fréquence d'impulsions ou le rapport d'impulsions, de l'excitation du plasma.

**7.** Procédé selon l'une quelconque des revendications précédentes, dans lequel

- pendant le dépôt de la zone barrière (202)

■ la proportion (C) de gaz réactif vaut $25 \leq C \leq 250$, de préférence $50 \leq C \leq 100$ et/ou
■ l'énergie d'excitation (E) par rapport à la masse vaut $400\ kJ/kg \leq E \leq 2\ 700\ kJ/kg$, de préférence $1\ 800\ kJ/kg \leq E \leq 2\ 200\ kJ/kg$ et/ou

- pendant le dépôt de la zone de passivation (203)

■ la proportion (C) de gaz réactif vaut $0 \leq C \leq 20$, de préférence $0 \leq C \leq 10$ et/ou
■ l'énergie d'excitation (E) par rapport à la masse vaut $30\ kJ/kg \leq E \leq 1\ 700\ kJ/kg$, de préférence $500\ kJ/kg \leq E \leq 800\ kJ/kg$ et/ou

- pendant le dépôt de la zone d'adhérence (201)

■ la proportion (C) de gaz réactif vaut $0 \leq C \leq 50$, de préférence $0 \leq C \leq 30$ et/ou
■ l'énergie d'excitation (E) par rapport à la masse vaut $20\ kJ/kg \leq E \leq 200\ kJ/kg$, de préférence $30\ kJ/kg \leq E \leq 140\ kJ/kg$

**8.** Procédé selon l'une quelconque des revendications précédentes, dans lequel le mélange de gaz de processus (PGM) contient un ou plusieurs précurseurs (PG, PG1, PG2) contenant du silicium, en particulier des composés organosiliciés, des siloxanes, silazanes ou silanes, de préférence de l'hexaméthyldisiloxane (HMDSO) et/ou de l'hexaméthyldisilazane (HMDSN), et/ou le gaz réactif (RG) comprend de l'oxygène.

**9.** Procédé selon l'une quelconque des revendications précédentes, dans lequel pour le dépôt de la zone barrière (202) l'hexaméthyldisilazane (HMDSN) est utilisé en tant que précurseur (PG1) et pour le dépôt d'adhérence (201) et/ou de la zone de passivation (203) l'hexaméthyldisiloxane est utilisé en tant que précurseur (PG2).

**10.** Revêtement sur un substrat en matière plastique (100), en particulier pour un récipient en matière plastique, destiné à la formation d'une barrière de migration chimiquement résistante, le revêtement (200) comprenant une ou plusieurs couches à gradient (200', 200", 200'''), ladite au moins une couche à gradient contenant des composés organosiliciés. $(SiO_xC_yH_z)$ qui ont été déposées à partir d'un ou de plusieurs précurseurs contenant du silicium, en particulier des siloxanes, silazanes ou silanes, au moins une couche à gradient comprenant au moins une zone barrière (202) essentiellement de type oxyde et une zone de passivation (203) essentiellement organique, la composition chimique de la couche à gradient étant modifiée progressivement à partir du côté substrat du revêtement (210) dans le sens (x) de l'accumulation des couches et passe d'au moins une zone barrière (202) à une zone de passivation (203), la structure chimique de la couche à gradient pouvant être déterminée par un paramètre de structure V mesurable par spectroscopie infrarouge à transformée de Fourier (FT-IR)

$$V = \frac{A + B + E}{C + D}$$

A : extinction à W = 1 376 cm$^{-1}$
B : extinction à W = 1257 cm$^{-1}$
E : extinction à W = 839 cm$^{-1}$
C : extinction à W = 440 cm$^{-1}$, 1 010 cm$^{-1}$ à 1 035 cm$^{-1}$, 1 070 cm$^{-1}$
D : extinction à W = 930 cm$^{-1}$

**caractérisé en ce qu'**à son maximum (S3) dans la zone de passivation (203) le paramètre de structure V est > 0,2.

11. Revêtement selon la revendication 10, dans lequel une couche à gradient (200') comprend en outre au moins une zone d'adhérence (201) essentiellement organique entre une zone barrière (202) et le côté substrat (210).

12. Revêtement selon la revendication 10 ou 11, dans lequel le paramètre de structure V à l'extremum (S2) de la zone barrière (201) est moins élevé qu'à l'extremum (S3) de la zone de passivation (203).

13. Revêtement selon l'une quelconque des revendications précédentes, dans lequel le paramètre de structure V à l'extremum (S2) de la zone barrière (201) est V < 0,2, de préférence V < 0,05.

14. Revêtement selon l'une quelconque des revendications précédentes, dans lequel le paramètre de structure V à l'extremum (S3) de la zone de passivation (203) est V > 0,35.

15. Revêtement selon la revendication 11, dans lequel le paramètre de structure V à l'extremum (S1) de la zone d'adhérence (201) est 0,1 V < 0,3.

16. Récipient en matière plastique comportant un revêtement selon l'une quelconque des revendications précédentes.

# Fig. 1

# Fig. 2

# Fig. 3

## Fig. 4

## Fig. 5

## Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3632748 A1
- DE 102006048658 A1
- EP 0718418 A1
- DE 4238279 A1
- EP 2630273 B1
- DE 19732217 C2
- DE 10139305 A1
- WO 0194448 A2
- US 2009148633 A1